# EUROPEAN PATENT APPLICATION

(11) **EP 2 495 295 A1**
(43) Date of publication of application: **05.09.2012**
(21) Application number: 12157907.2
(22) Date of filing: 02.03.2012
(51) Int. Cl.: C09J 7/02, C09J 7/04, H01L 21/00

(54) **Tackiness adhesive sheet for thin-film substrate fixing**

(30) Priority: 04.03.2011 JP 2011048374
(71) Applicant: Nitto Denko Corporation, Ibaraki-shi, Osaka 567-8680 (JP)
(72) Inventor: Shintani, Toshio, Ibaraki-shi, Osaka 567-8680 (JP); Arimitsu, Yukio, Ibaraki-shi, Osaka 567-8680 (JP)
(74) Representative: Grünecker, Kinkeldey, Stockmair & Schwanhäusser

(57) **Abstract**

The present invention provides a manufacturing method for efficiently and stably forming a pattern on a thin-film substrate. A thin-film substrate, a tackiness adhesive sheet for thin-film substrate fixing, and a hard substrate are laminated in this order and a porous base material functioning as a core material of the tackiness adhesive sheet for thin-film substrate fixing has bore holes. Therefore, even if preliminary heating and drying is not applied, air bubbles are not generated between the thin-film substrate and the tackiness adhesive sheet for fixing during pattern formation on the thin-film substrate. This makes it possible to stably and efficiently form a pattern.

## Description

### BACKGROUND OF THE INVENTION

### Field of the invention

The present invention relates to a tackiness adhesive sheet for thin-film substrate fixing and a method of forming a pattern on a thin-film substrate and, more particularly, to a tackiness adhesive sheet for thin-film substrate fixing used in pattern formation on a thin-film substrate in manufacturing such as a film manufacturing process for a flexible circuit board (FPC) or a base substrate of an organic EL panel, a driving circuit of an electronic paper or a flexible display, a passive matrix or a color filter, a circuit board of a touch panel, or a solar cell and a method of manufacturing the pressure-sensitive adhesive sheet.

### Description of the Related Art

In the past, a circuit board, a base substrate of an organic EL panel, and a substrate of a color filter and the like have rigidity because of the thickness thereof. Therefore, during pattern formation on these substrates, it is possible to fix the substrates in an accurate position and perform pattern formation on the substrates without having difficulties in handling such as fixing and movement of the substrates. Actually, a driving circuit and the color filter are usually formed on a glass substrate. No problem occurs during pattern formation on such a glass substrate having sufficient rigidity.

However, recently, concerning components in an electronic device and a display, more specifically, a flexible circuit board (FPC) or a base substrate of an organic EL panel, a TFT (a driving circuit) of an electronic paper or a flexible display, a passive matrix or a color filter, a circuit board of a touch panel, or a solar cell, development of a type of a component having characteristics that the component is light in weight, less easily broken by an impact, and thin is in progress.

In this case, the driving circuit, the passive matrix, the color filter, the circuit board of the touch panel and the like are not the glass substrate in the past. It is necessary to form a pattern on a metal foil or a plastic substrate having so-called heat resistivity. However, since the metal foil and the plastic substrate are thin films, there are many problems such as difficulties in accurate fixing and conveyance.
In particular, when pattern formation is performed, a positional displacement is caused by slight deformation of a substrate. As a result, yield is substantially deteriorated. Even if the substrate is fixed using an adhesive plate including a porous plate, a small hollow of an adhesive portion of the adhesive plate causes a positional displacement. As a result, for example, yield is deteriorated.

Therefore, in an attempt to develop an (α-Si TFT-EPD display, Phillips Corporation proposes a method of applying polyimide on glass and then peeling a polyimide substrate from the glass using a transfer technique. However, in this case, it is necessary to use laser annealing to remove the glass substrate. As a result, new equipment is necessary and, from a viewpoint of heat resistance, an inexpensive thin-film substrate cannot be used.
Further, recently, a Roll to Roll formation process is also attempted. However, in this case, since the process is not a batch process in the past, the existing TFT equipment cannot be used and new equipment is necessary. Several problems due to rotation and contact of a rolled substrate have to be overcome.

On the other hand, it is also attempted to temporarily fix a substrate using an adhesive tape having a so-called base material and peeling the substrate after pattern formation. However, a largest problem is that, after a thin-film substrate is affixed via the adhesive tape stuck to a hard substrate, when the thin-film substrate is put in a heating process for pattern formation, it is likely that air bubbles are formed between the thin-film substrate and the adhesive tape and a pattern formation failure occurs. Therefore, under the present situation, after the adhesive tape is affixed with the hard substrate, it is necessary to sufficiently put the adhesive tape through a preliminary drying process for removing moisture in the base material of the adhesive tape. Even the adhesive tape subjected to preliminary drying once absorbs moisture from a tape cross section unless the adhesive tape is not put through a pattern formation processing within thirty minutes to one hour. A serious problem of the formation of air bubbles occurs unless the preliminary drying is performed again. Further, in the pattern formation process in this field, every time each layer is formed, it is necessary to put the adhesive tape through a chemical treatment process called a development process for removing an unnecessary portion. In this process, since the adhesive tape absorbs moisture, it is necessary to always put the adhesive tape through the preliminary heating process before pattern formation of each layer. As a result, the operating ratio of expensive equipment for performing pattern formation is reduced and costs are extremely high.

As an example of the related art, there is Japanese Patent Application Laid-Open Publication No. 2010-39472.

It is an object of the present invention to provide a method of forming a pattern on a thin-film substrate used in a component in an electronic device, a display, or the like, wherein, even if the thin-film substrate is used, the thin-film substrate can be accurately fixed and conveyed, the pattern can be formed without displacement of a position, the thin-film substrate can be fixed without air bubbles and deformation even if a double sided tape is not dried beforehand, and the pattern can be formed extremely efficiently and stably.

### SUMMARY OF THE INVENTION

The present invention has been devised to solve the problems in the past. Even if a thin-film substrate is used, the thin-film substrate can be fixed without air bubbles and deformation by fixing the thin-film substrate via a tackiness adhesive tape including a porous base material having bore holes on a hard substrate. Therefore, the present invention provides a method of making it possible to stably perform pattern formation without causing positional displacement and taking out the thin-film substrate without damage after conveyance. For that purpose, means explained below is adopted.

1. A tackiness adhesive sheet for thin-film substrate fixing used in performing pattern formation on a thin-film substrate, wherein the pattern formation is performed in a state in which the thin-film substrate, the tackiness adhesive sheet for fixing, and a hard substrate are laminated in order, the tackiness adhesive sheet for fixing in use includes a porous base material, a porosity of the porous base material is 5% to 95%, and a hole diameter of the porous base material is 0.01 µm to 900 µm.
2. The tackiness adhesive sheet for thin-film substrate fixing described in 1, wherein a hole area of the porous base material of the tackiness adhesive sheet for fixing is 0.0001 µm² to 4 mm².
3. The tackiness adhesive sheet for thin-film substrate fixing described in 1 or 2, wherein multiple holes of the porous base material are formed of bore holes, and the bore holes are continuously opened through from the porous base material to a tackiness adhesive agent layer.
4. The tackiness adhesive sheet for thin-film substrate fixing described in any one of 1 to 3 includes a tackiness adhesive agent layer for re-peeling in at least one piece of the porous base material.
5. The tackiness adhesive sheet for thin-film substrate fixing described in any one of 1 to 4, wherein CTE at 150°C of the porous base material is equal to or lower than 500 ppm.
6. The tackiness adhesive sheet for thin-film substrate fixing described in any one of 1 to 5, wherein the tackiness adhesive sheet for thin-film substrate fixing is used when formation of a pattern on the thin-film substrate including a process performed at 80°C to 270°C is performed.
7. A member for thin-film substrate fixing formed by laminating the tackiness adhesive sheet for thin-film substrate fixing described in any one of 1 to 6 on a hard substrate.
8. A method of forming a pattern on a thin-film substrate in a state in which the thin-film substrate, a tackiness adhesive sheet for fixing, and a hard substrate are laminated in order, wherein the tackiness adhesive sheet for thin-film substrate fixing described in any one of 1 to 6 is used as the tackiness adhesive sheet for fixing.

The present invention realizes effects explained below through the means explained above.
The tackiness adhesive sheet for thin-film substrate fixing in which the base material functioning as the porous base material includes the bore holes in the present invention is a material for primarily provisionally fixing the hard substrate for pattern formation and the thin-film substrate under a high-temperature atmosphere of 80°C to 270°C. Even if prior heat treatment necessary in the normal adhesive tape is not performed, a deficiency of floating due to heating in a pattern formation process is not caused. This enables efficient and stable pattern formation. Consequently, it is possible to increase an apparatus operating ratio and provide an inexpensive circuit member.
Further, unlike the method according to the related art, pattern formation can be performed efficiently and stably without causing air babbles and positional displacement. Therefore, it is possible to realize improvement of yield. It is possible to obtain a method of making it possible to adopt a batch process using an inexpensive heat resistant substrate without requiring an annealing process. Consequently, it is possible to provide a pattern forming method.

### BRIEF DESCRIPTION OF THE DRAWINGS

Fig. 1 is a sectional view of a thin-film substrate fixed to a hard substrate using a tackiness adhesive sheet for thin-film substrate fixing according to the present invention; and
Fig. 2 is a sectional view of the tackiness adhesive sheet for thin-film substrate fixing according to the present invention.

### DETAILED DESCRIPTION OF THE PREFERRED EMBODIMENTS

The present invention is an invention for, when a pattern is formed on a thin-film substrate, preparing a hard substrate in advance and fixing the thin-film substrate to the surface of the hard substrate via a tackiness adhesive sheet for thin-film substrate fixing to thereby thereafter smoothly perform pattern formation to a process for peeling the thin-film substrate from a tackiness adhesive agent layer.

### Pattern

The pattern in the present invention refers to a circuit, a thin film, an element, and the like formed on the thin-film substrate necessary for using the thin-film substrate for applications such as a film manufacturing process for a flexible circuit board (FPC) or a base substrate of an organic EL panel, a driving circuit of an electronic paper or a flexible display, a passive matrix or a color filter, a circuit board of a touch panel, or a solar cell.
The pattern only has to be a pattern necessary for the applications. The shape and the material of the pattern do not matter.

### Hard substrate

A substrate used as the hard substrate is glass, a metal plate, and a semiconductor wafer and is not limited at all. The substrate only has to have sufficient strength and make it possible to form the tackiness adhesive sheet for thin-film substrate fixing in the present invention on the substrate and stably laminate the thin-film substrate, which is a target of formation of a pattern, on the tackiness adhesive sheet for thin-film substrate fixing.
The thickness of the hard substrate is 0.01 mm to 10 mm, more preferably 0.02 mm to 7 mm, and still more preferably 0.03 mm to 5 mm. The thickness of 0.01 mm to 10 mm is preferable in that it is easy to hold and convey the hard substrate and the hard substrate has shock resistance. A substrate that is easily held and has the shock resistance is more preferably thinner in this range of the thickness because the substrate is light in weight and is easily conveyed.

### Thin-film substrate

A substrate used as the thin-film substrate is a substrate including at least one or more layers. It is possible to use polyimide, polycarbonate, polyether sulfone, polyacrylate, polyamide, polynorbornene, polyethylene terephthalate, polyethylene naphthalate, polyether etherketone, polyamideimide, polyether imide, polyaramide, polyphenylene sulfide, styrene foil, and the like.
Other materials may be used as the thin-film substrate as long as the materials can be used for the applications such as a film manufacturing process for a flexible circuit board (FPC) or a base substrate of an organic EL panel, a driving circuit of an electronic paper or a flexible display, a passive matrix or a color filter, a circuit board of a touch panel, or a solar cell.
The configuration of the thin-film substrate is not limited to a single layer and may be plural layers and multiple layers. A processing layer may be provided on any surface for improvement of abrasion resistance and smoothness and improvement of moisture barrier properties.
The surface roughness of the thin-film substrate is not particularly limited. However, a surface on which a pattern is formed is preferably smooth. In this regard, Rmax is preferably smaller than 10 µm and more preferably smaller than 5 µm.
The thickness of the thin-film substrate needs to be thickness for enabling final assembly simultaneously with a reduction in weight and thickness. Therefore, the thickness is 5 µm to 3 mm, preferably 7 µm to 2.5 mm, and more preferably 10 µm to 2.5 mm.

When prevention of bending and the like due to handling in a pattern formation process is taken into account, the thin-film substrate preferably has a certain degree of a modulus of elasticity. Specifically, the modulus of elasticity is preferably equal to or higher than 100 MPa and more preferably equal to or higher than 200 Mpa. If the thin-film substrate is a film having a modulus of elasticity equal to or higher than 100 Mpa, in handling after pattern formation, creases and bends do not frequently occur in the thin-film substrate and yield is not deteriorated. Further, a disadvantage of a film having a low modulus of elasticity in that, in general, the film is softened and fused by heating and it is difficult to use the film is solved.
When handlability and deformation control at the room temperature are taken into account, glass transfer temperature (Tg) of the thin-film substrate is preferably equal to or higher than 23°C.

In particular, in formation of a TFT (a driving circuit), a color filter, and a circuit board of a touch panel, in general, the thin-film substrate is processed under a heating process at temperature equal to or higher than 150°C. When a material having a large CTE value (coefficient of linear expansion) is used, because of a difference between CTE values of the thin-film substrate and the hard substrate, expansion and contraction during the pattern formation occurs and displacement and the like during circuit formation occur. As a result, a problem such as deterioration in yield occurs. Therefore, this value is important.
Specifically, a thin-film substrate having a CTE value lower than 400 ppm at 150°C can be used. It is desirable to use a thin-film substrate having preferably a CTE value lower than 350 ppm and more preferably a CTE value lower than 300 ppm. When the CTE value at 150°C is equal to or higher than 400 ppm, in pattern formation at temperature equal to or higher than 150°C, positional displacement during formation of circuit layers occurs. As a result, yield is deteriorated.

### Porous base material of the tackiness adhesive sheet for thin-film substrate fixing

Examples of a base material used as the porous base material of the tackiness adhesive sheet for thin-film substrate fixing include a film formed of at least one layer or more of polyethylene terephthalate, polyurethane, polytetrafluoroethylene, polyamide, polyimide, polycarbonate, polyether sulfone, polyacrylate, polynorbornene, polyethylene naphthalate, polyether etherketone, polyamideimide, polyether imide, polyaramide, polyphenylene sulfide, polystyrene, fluorine resin, and the like, polymer fiber of polyurethane, polystyelene, or polyethylene terephthalate, synthetic fiber of rayon, cellulose acetate, or the like, inorganic fiber such as glass fiber or carbon fiber or a mixture of these kinds of fibers, and non-woven fabric made of paper and woven fabric. Other materials may be used without limit. When the material of the base material is formed of fiber, as a result of a fiber-to-fiber gap, the material naturally has bore holes. Concerning a film not having bore holes from the beginning, bore holes can be formed by a method explained below.

Examples of the method include punching by a press machine (Thomson press, etc.) or a rotating roller (a punching machine or a rotating roller with needles), a laser, a heavy ion beam, a drill, water jet treatment, and etching treatment by a chemical. Besides, as a method of once forming a porous base material on a process film and then extracting the porous base material, various methods such as a phase transition method, a stretching method, a fusing method, and a sintering method can be adopted.
The thickness of a film having such bore holes is preferably thickness of 1 µm to 3 mm, more preferably 3 µm to 2.5 mm, and still more preferably 5 µm to 1 mm. When the thickness is larger than 1 µm, ventilation performance is sufficient and the thin-film substrate has sufficient rigidity when the tackiness adhesive sheet for thin-film substrate fixing is affixed. Therefore, creases and bends less easily occur and in-plane uniformity necessary for the tackiness adhesive sheet for thin-film substrate fixing can be maintained.

Further, the porosity of the porous base material is preferably 5% to 95%, more preferably 5% to 90%, and still more preferably 10% to 80%. If the porosity is equal to or higher than 5%, the ventilation performance is sufficient. Dehumidification characteristics as an object of the present invention can be obtained. In the case of the porosity equal to or lower than 95%, rigidity intrinsic to the base material can be maintained. During a tackiness adhesive agent layer formation process or affixing with the hard substrate, the base material is not easily deformed. In-plane uniformity necessary as a fixing material can be maintained. By adopting such a porous base material, gas such as water and the like caused during heating does not stay between the tackiness adhesive sheet for thin-film substrate fixing and the thin-film substrate. Floating does not occur on the thin-film substrate.
A hole diameter is preferably 0.01 µm to 900 µm and more preferably 0.01 µm to 700 µm. When the hole diameter is equal to or larger than 0.01 µm, the dehumidification characteristics as the object of the present invention can be obtained. When the hole diameter is equal to or smaller than 900 µm, even if the thin-film substrate on which a pattern is formed is affixed, a hollow does not occur in the bore hole portion and in-plane height uniformity can be maintained. A hole area is preferably a size of 0.0001 µm² to 4 mm². The bore holes are preferably continuous air bubbles rather than independent air bubbles from the viewpoint of dehumidification.
The porous base material having such bore holes may be subjected to processing for improving moisture proof and adhesiveness with a tackiness adhesive agent such as corona discharge treatment, flame treatment, plasma treatment, sputter etching treatment, undercoating (e.g., primer), fluorine treatment, and fat removal treatment by a chemical. In particular, it is desirable that the porous base material is subjected to undercoating treatment or corona treatment.

### Tackiness adhesive composition

A tackiness adhesive composition needs to be a composition that can fix the thin-film substrate to the hard substrate with sufficient tackiness adhesive properties because of a role of affixing and fixing of the hard substrate and the thin-film substrate via the tackiness adhesive sheet for thin-film substrate fixing. The tackiness adhesive in the present invention contains an agent functioning as a tackiness agent or an adhesive agent.
As such a tackiness adhesive agent, it is possible to use an organic adhesive, specifically, a natural rubber adhesive, an α-olefin adhesive, an urethane resin adhesive, an ethylene-vinyl acetate resin emulsion adhesive, an ethylene-vinyl acetate hot melt adhesive, an epoxy resin adhesive, a vinyl chloride resin fat solvent adhesive, chloroprene rubber adhesive, a cyanoacrylate adhesive, a silicone adhesive, a styrene-butadiene rubber solvent adhesive, a nitrile rubber adhesive, a nitrocellulose adhesive, a reactive hot melt adhesive, a phenol resin adhesive, a modified silicone adhesive, a polyamide resin hot melt adhesive, a polyimide adhesive, a polyurethane resin hot melt adhesive, a polyolefin resin hot melt adhesive, a polyvinyl acetate resin solvent adhesive, a polystyrene resin solvent adhesive, a polyvinyl alcohol adhesive, a polyvinyl pyrrolidone resin adhesive, a polyvinyl butyral adhesive, a polybenzimidazole adhesive, a polymethacrylate resin solvent adhesive, a melamine resin adhesive, a urea resin adhesive, resorcinol adhesive, and the like and tackiness agent formed by these kinds of resin. Other materials may be used without limit.

As the tackiness adhesive composition, more specifically, a rubber, acrylic, silicone, and urethane tackiness adhesive agent may be used or other materials may be used without limit. As a specific example, an acrylic tackiness adhesive agent is explained. However, other material may be used without limit.
The tackiness adhesive composition may contain, other than a tackiness component (base polymer), an appropriate additive such as a crosslinking agent (e.g., polyisocyanate or alkyl ether melamine), a tackifier (e.g., rosin derivative resin, polyterepene resin, petroleum resin, or fat soluble phenol resin), rubber, a plasticizer, a filler, or an antioxidant.

When the tackiness adhesive sheet for thin-film substrate fixing is formed using the porous base material, a double-sided tackiness adhesive sheet for thin-film substrate fixing can be formed by applying the same treatment to the opposite surface. In the case of the tackiness adhesive sheet for thin-film substrate fixing provided with an adhesive layer only on one surface, a surface not having a tackiness adhesive agent layer can be affixed with the hard substrate surface and fixed by using a hard substrate in which through-holes are opened and attracting the surface from the hard substrate surface side.
As explained above, as the tackiness adhesive agent, more specifically, rubber, acrylic, silicone, and urethane tackiness adhesive agents may be used or other materials may be used without limit. As a specific example, the acrylic tackiness adhesive agent is explained. However, other materials may be used without limit.
In particular, when a pattern is formed on the surface to which the thin-film substrate is fixed, a sufficient tack force is necessary. However, after the pattern formation, the thin-film substrate needs to be taken out without stress and damage. Therefore, compared with the adhesive, it is preferable to use the tackiness adhesive agent.
Such a tackiness adhesive agent is solved in an organic solvent or water as appropriate and applied on a release liner using means such as a bar coater, a Meier bar, a roll coater, or a die coater and, when necessary, undergoes a drying process, whereby the tackiness adhesive agent layer can be formed. Thereafter, the tackiness adhesive agent layer is affixed with the porous base material, whereby an adhesive sheet can be formed. When the tackiness adhesive agent layers are formed on both surfaces, the tackiness adhesive sheet for thin-film substrate fixing having tackiness layers on both surfaces can be formed by repeating this operation.

The thickness of the tackiness adhesive agent layer is preferably 0.1 µm to 800 µm and more preferably 0.1 µm to 700 µm. A double-sided tape obtained by applying the same or different tackiness adhesive agents on both surfaces via the porous base material may be used without a problem. A total thickness in this case is 1 µm to 6 mm, preferably 1 µm to 3 mm, and more preferably 1 µm to 2.5 mm. When the total thickness is larger than 1 µm, it is possible to obtain an adhesive force sufficient for thin-film substrate fixing. If the total thickness is equal to or smaller than 1 mm, the tackiness adhesive agent and the porous base material are not damaged in a chemical process equivalent to the post process of the pattern formation process. Therefore, the chemical does not intrude from an end. It is unlikely that a deficiency of fixing and deficiency of delamination are caused. From the viewpoint of the dehumidification characteristics, it is essential that the porous base material includes the bore holes. It is more preferable that the tackiness adhesive agent also includes bore holes. More preferably, the porous base material and the tackiness adhesive agent layer of the tackiness adhesive sheet for thin-film substrate fixing are pierced through in the same position. In this case, the dehumidification characteristics as the original object of the present invention are obtained. Moreover, as a result, in a peeling process for the thin-film substrate, an area in which the tackiness adhesive agent layer is in contact decreases. As a result, the thin-film substrate after the pattern formation can be taken out without damage and stress and yield can be improved.
When the tackiness adhesive agent layer is provided on the porous base material, if the fluidity of the tackiness adhesive agent is high, it is highly likely that the holes of the porous base material are closed. Therefore, to prevent such closure of the holes, it is important to form the tackiness adhesive agent layer.

A storage modulus of the composition forming the tackiness adhesive agent layer is preferably 1×10⁴ to 1×10⁷ Pa between 23°C and 150°C. If the storage modulus is equal to or higher than 1×10⁴ Pa, the tackiness adhesive agent layer can suppress expansion and contraction of the thin-film substrate during pattern formation. As a result, the thin-film substrate is not deformed. Therefore, pattern displacement is not caused. On the other hand, if the storage modulus is equal to or lower than 1×10⁷ Pa, adhesiveness to the hard substrate and the thin-film substrate can be obtained and floating and peeling are not caused. There is no particular problem because these storage moduli can be adjusted by adding silica, a tackifier, or a plasticizer besides a curing agent including a crosslinking agent.
The pattern formation process is often treated in a heating environment of 80°C to 270°C for about 20 minutes to 3 hours. Therefore, in the tackiness adhesive sheet, in this application, a value of a tack force after heating at 150°C for one hour is desirably within three times as large as a measurement value before the heating. The tackiness adhesive sheet having the tack force within three times as large as the measurement value after the heating does not completely follow fine unevenness of the thin-film substrate. Therefore, it is not difficult to peel the tackiness adhesive sheet.

To suppress wettability due to heating of the tackiness adhesive agent with respect to the thin-film substrate, glycidyl methacrylate and acrylic acid may be co-polymerized in acrylic polymer and heat-cured by the heating process during the pattern formation to suppress the wettability. As another method, in order to suppress a rise in the tack force after heating with respect to before heating, it is also effective to suppress a weight percentage of the acrylic acid to the entire acrylic monomer to be smaller than 7% during polymerization. Besides, a component such as a plasticizer, a wax, a surface active agent, or silica for reducing a contact area may be added without a problem.

In the peeling process for the thin-film substrate, a peeling tack force at 180 degrees at peeling speed of 300 mm/minute is equal to or lower than 2N/10mm, preferably equal to or lower than 1.5N/10mm, and more preferably equal to or lower than 1.0N/10mm.
When the peeling tack force is equal to or higher than 2N/10mm, it is not easy to peel the thin-film substrate. As a result, the thin-film substrate is damaged during peeling. The thin-film substrate and a pattern formed on the thin-film substrate are scratched and efficiency percentage is deteriorated. In the peeling process, a substantial peeling force is preferably as close as possible to zero because damage during peeling does not occur.

As explained above, the tack force is desirably high in the pattern formation process. However, it is necessary to peel the thin-film substrate from the tackiness adhesive agent layer after the pattern is formed on the thin-film substrate. Therefore, during peeling of the thin-film substrate, it is important to smoothly peel the thin-film substrate without stress and damage due to excessive force applied to the thin-film substrate.

From such viewpoints, it is possible to use a tackiness adhesive composition, a tackiness adhesive force of which can be reduced by irradiating an energy line such as an ultraviolet ray or an electron ray, or a tackiness adhesive composition formed of a composition, a tackiness adhesive force of which can be reduced by heating.
As the tackiness adhesive composition, a tackiness adhesive force of which can be reduced by irradiating an energy line such as an ultraviolet ray or an electron ray, for example, when an acrylic composition is used, it is possible to use a tackiness adhesive composition obtained by mixing a compound called photoinitiator in an organic solvent by using polymer introduced by C=C bond in a polymer backbone and adding a compound containing C2=C2 bond called acrylate or urethane oligomer.
A predetermined tackiness adhesive sheet can be obtained by applying the tackiness adhesive composition on the peeling linear with the bar coater and then drying the tackiness adhesive composition at 120°C for 5 minutes. The tack force of the tackiness adhesive sheet for thin-film substrate fixing obtained in this way can be easily reduced by ultraviolet ray irradiation.
Besides, as a method of reducing the tack force with heating, it is also possible to use a method of applying a micro capsule of "Micro-sphere series" or the like sold by Matsumoto Yushi-Seiyaku Co., Ltd. and the like mixed with the tackiness adhesive composition to generate physical unevenness on an interface between the tackiness adhesive agent and an adherend thorough expansion of the micro capsule due to heating and, as a result, change the tackiness adhesive force to minimum.

As the tackiness adhesive composition, the tackiness adhesive force of which can be reduced by heating, a tackiness adhesive composition obtained by mixing a foaming agent such as the micro capsule of "Microsphere series" or the like sold by Matsumoto Yushi-Seiyaku Co., Ltd. or the like in the tackiness adhesive agent is adopted. In the tackiness adhesive agent layer obtained by applying the tackiness adhesive composition, physical unevenness is caused on the interface between the cohesive agent layer and the adherend because of foaming and expansion of the micro capsule due to heating. A contact area of the thin-film substrate and the tackiness adhesive agent layer is remarkably reduced. As a result, it is possible to change the tackiness adhesive force to the minimum. As a result, it is possible to easily peel the thin-film substrate from the foaming tackiness adhesive agent layer.
In particular, as the tackiness adhesive composition, the tack force of which can be reduced by heating, a composition that does not restrain, as much as possible, expansion and/or foaming of a foaming agent such as thermal expansion microspheres during heating is preferable. It is possible to use, in combination, one kind or two or more kinds of publicly-known tackiness adhesive agents such as a rubber tackiness agent, an acrylic tackiness agent, a vinyl alkyl ether tackiness agent, a silicone tackiness agent, a polyester tackiness agent, a polyamide tackiness agent, a urethane tackiness agent, a styrene-diene block copolymer tackiness agent, and a creep characteristic improved tackiness agent obtained by mixing thermo-fusible resin having a melting point equal to or lower than about 200°C in these tackiness agents.

When a crosslinking agent is added to the tackiness adhesive composition, a dosage of the crosslinking agent is preferably 0.01 to 10 pts.wt. and more preferably 0.01 to 8 pts.wt. with respect to 100 pts.wt. of base polymer. As the crosslinking agent, a crosslinking agent such as isocyanate crosslinking agent, an epoxy crosslinking agent, a melamine crosslinking agent, a thiuram crosslinking agent, a resin crosslinking agent, or metal chelate can be used.

The thermal expansion microspheres only have to be microspheres obtained by containing a substance that is easily gasified and expanded by heating such as isobutane, propane, or pentane in a core having elasticity. The core is often formed of a thermo-fusible substance or a substance destroyed by thermal expansion. Examples of the substance forming the core include a vinylidene chloride-acrylonitrile copolymer, polyvinyl alcohol, polyvinyl butyral, polymethyl methacrylate, polyacrylonitrile, polyvinylidene chloride, and polysulfone. The thermal expansion microspheres can be manufactured by a commonly-used method such as a coacervation method or an interfacial polymerization method. As the thermal expansion microspheres of the present invention, for example, a commercially available product such as a commodity name "Matsumoto microsphere F30D, F50D" manufactured by Matsumoto Yushi-Seiyaku Co., Ltd can also be used.

To efficiently reduce the adhesive force of the tackiness adhesive agent layer through heating treatment, thermal expansion microspheres having appropriate strength that do not burst until a coefficient of cubic expansion increases to be five times or more, above all, seven times or more, in particular, ten times or more are preferable.

A mixing amount of the foaming agent such as the thermal expansion microspheres can be appropriately set according to a lowering property or the like of an expansion ratio and the tack force (adhesive force) of the tackiness adhesive agent layer. However, in general, the mixing amount is, for example, 1 to 150 pts.wt. and, preferably 5 to 100 pts.wt. with respect to 100 pts.wt. of the base polymer (e.g., in the case of an acrylic tackiness agent, acryl polymer) forming the tackiness adhesive agent layer. When the mixing amount of the foaming agent such as the thermal expansion microspheres is smaller than 1 pts.wt., in some case, sufficiently easy peeling properties cannot be displayed. On the other hand, when the mixing amount exceeds 150 pts.wt., in some case, the surface of the tackiness adhesive agent layer becomes uneven and adhesiveness is deteriorated.
In particular, in the present invention, the thin-film base material only has to be easily peeled so as not to be destroyed. When a thin tackiness adhesive agent layer is formed, in stably forming a surface state, it is preferable to suppress the mixing amount of the forming agent such as the thermal expansion microspheres to some extent. In this regard, a mixing amount (30 to 80 pts.wt.) about a half of a mixing amount necessary for complete peeling (the tack force is zero) is optimum.

Thermal expansion start temperature of the tackiness adhesive agent layer of the present invention is appropriately determined according to heat resistance of the thin-film base material and a layer formed on the thin-film base material and is not specifically limited. The "thermal expansion start temperature" in the present invention is temperature at which expansion of the thermal expansion microspheres started when the foaming agent such as the thermal expansion microspheres are measured by an expansion method (load: 19.6 N, probe: 3 mmφ) using a thermal analyzer (a product name "TMA/SS6100") manufactured by SII NanoTechnology Inc.).

The thermal expansion start temperature can be appropriately controlled according to a type, grain diameter distribution, and the like of the foaming agent such as the thermal expansion microspheres. In particular, the thermal expansion start temperature can be easily controlled by classifying the thermal expansion microspheres and sharpening the grain diameter distribution of the thermal expansion microspheres in use. As a classifying method, a publicly-known method can be used. Either a dry type or a wet type may be used. As a classifying apparatus, a publicly-known classifying apparatus such as a gravity classifier, an inertia classifier, or a centrifugal classifier can be used.
The thickness of the tackiness adhesive agent layer containing the thermal expansion microspheres is, for example, 3 µm to 700 µm and, preferably, 5 µm to 600 µm.
In the case of the tackiness adhesive agent layer containing the thermal expansion microspheres, the thickness only has to be larger than a maximum grain diameter of the contained thermal expansion microspheres. In this case, the thermal expansion microspheres do not form unevenness on the surface of the layer formed of the tackiness adhesive composition.

### Separator

In the present invention, after the tackiness adhesive agent layer is formed, before the tackiness adhesive agent layer is laminated on the porous base material, in some case, a release liner can be laminated as a separator for the purpose of preventing contamination of the surface of the tackiness adhesive agent layer.
The separator in use is not specifically limited. Publicly-known release paper or the like can be used. For example, it is possible to use a base material including a release layer of a plastic film or paper subjected to surface treatment with a silicone, longchain alkyl, fluorine, or molybdenum sulfide release agent, a low adhesive base material formed of fluorine polymer such as polytetrafluoroethylene, polychlorotrifluoroethylene, polyvinyl fluoride, polyvinylidene fluoride, a tetrafluoroethylenehexafluoropropylene copolymer, or a chlorofluoroethylene/vinylidene fluoride copolymer, or a low adhesive base material formed of non-polar polymer such as olefin resin (e.g., polyethylene or polypropylene).
Even after the tackiness adhesive agent layer formed on the separator is laminated on the porous base material, it is also possible not to peel the separator until immediately before the use.

### Method of manufacturing the tackiness adhesive sheet for thin-film substrate fixing

As a method of manufacturing the tackiness adhesive sheet for thin-film substrate fixing according to the present invention, the porous base material for various tackiness adhesive sheet for thin-film substrate fixing is prepared.
A tackiness adhesive agent layer can be formed by applying a tackiness adhesive agent on the porous base material using arbitrary application means such as a bar coater, a Meier bar, a roll coater, or a die coater and subsequently drying the tackiness adhesive agent. It is possible to adopt means for forming a tackiness adhesive agent layer by applying the tackiness adhesive agent on the separator with the arbitrary means such as the bar coater, the Meier bar, the roll coater, or the die coater and drying the tackiness adhesive agent and forming a tackiness adhesive agent layer on the porous base material by transferring the formed layer onto the porous base material.

It is possible to form the tackiness adhesive agent layer on one surface of the porous base material and form the tackiness adhesive sheet for thin-film substrate fixing. When adhesive agent layers are formed on both surfaces to form the tackiness adhesive sheet for thin-film substrate fixing, it is possible to apply the same processing to the opposite surface to form a double-sided tackiness adhesive sheet for thin-film substrate fixing. In the case of the tackiness adhesive sheet for thin-film substrate fixing provided with an adhesive layer only on one surface, a surface not having a tackiness adhesive agent layer can be affixed with the hard substrate surface and fixed by using a hard substrate in which through-holes are opened and attracting the surface from the hard substrate surface side.
As explained above, such a tackiness adhesive agent is solved in an organic solvent or water as appropriate and applied on a release liner using the bar coater or the Meier bar and, when necessary, undergoes the drying process, whereby the tackiness adhesive agent layer can be formed. Thereafter, the tackiness adhesive agent layer is affixed with the porous base material, whereby an pressure-sensitive adhesive sheet can be formed. When it is desired to form the tackiness adhesive agent layers on both surfaces, the tackiness adhesive sheet for thin-film substrate fixing having tackiness layers on both surfaces can be formed by repeating this operation.

From the viewpoint of the dehumidification characteristics, it is essential that the porous base material includes the bore holes. It is more preferable that the tackiness adhesive agent also includes bore holes. More preferably, the porous base material and the tackiness adhesive agent layer of the tackiness adhesive sheet for thin-film substrate fixing are pierced through in the same position.
Therefore, when a base material that is formed as a porous base material later but does not have bore holes yet is selected, after the tackiness adhesive agent layer is formed, it is possible to apply, to the tackiness adhesive layer and the base material, punching by a press machine (Thomson press, etc.) or a rotating roller (a punching machine or a rotating roller with needles), a laser, a heavy ion beam, a drill, water jet treatment, and etching treatment by a chemical.
In a process for providing the bore holes, it is possible to separately prepare a process film, laminate, on the process film, a base material on which a tackiness agent layer is formed, subsequently perforate holes in the base material including the process film, and finally adopt publicly-known release means such as phase transition, stretching, fusing, or sintering.
With such a process, the hole perforating process can be applied to the base material in which the tackiness adhesive agent layer is provided. A tacking adhesive sheet for thin-film substrate fixing to be obtained can be formed in a structure in which the porous base material and the tackiness adhesive agent pierce through in the same position.

When the porous base material is used, the tackiness adhesive sheet for thin-film substrate fixing can be formed by, for example, forming the tackiness adhesive agent layer on the separator, providing bore holes in the tackiness adhesive agent layer as well as the separator using the above described means and transferring the tackiness adhesive agent layer having the obtained bore holes onto the porous base material.
In this case, when synthetic fiber, inorganic fiber such as glass fiber or carbon fiber or a mixture of these kinds of fibers, non-woven fabric made of paper and woven fabric, or the like is selected as the porous base material, a large number of holes as bore holes are present in such a porous base material. Therefore, even when the tackiness adhesive agent layer in which the bore holes are provided is transferred, the bore holes of the tackiness adhesive agent layer can communicate with the bore holes of the porous base material.

### Method of using the tackiness adhesive sheet for thin-film substrate fixing

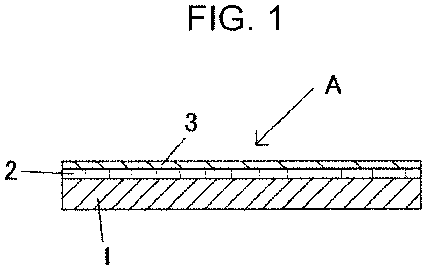

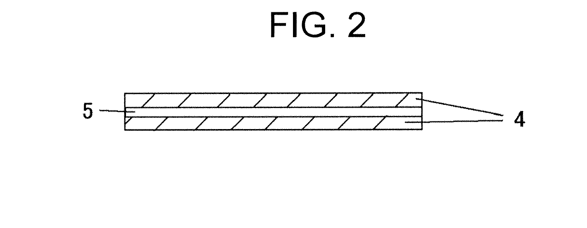

As the tackiness adhesive sheet for thin-film substrate fixing according to the present invention, as shown in Fig. 1, a tackiness adhesive sheet for thin-film substrate fixing 2 is provided on a hard substrate 1. A thin-film substrate 3 is laminated on the tackiness adhesive sheet for thin-film substrate fixing 2 and patterning A is applied to the thin-film substrate 3, whereby a circuit or the like necessary for various flexible displays is formed.
Among various kinds of the tackiness adhesive sheet for thin-film substrate fixing 2, a tackiness adhesive sheet for thin-film substrate fixing in which tackiness adhesive agent layers are formed on both surfaces includes a structure shown in Fig. 2. Tackiness adhesive layers 4 are provided on both surfaces of a porous base material.
The thin-film substrate 3 is fixed on the hard substrate 1 by affixing the thin-film substrate 3 and the hard substrate 1 using such a tackiness adhesive sheet for thin-film substrate fixing 2. Patterning for forming, with arbitrary means, a circuit and wiring on the thin-film substrate 3 fixed in this way can be performed.

### Flexible circuit board manufacturing process

When a flexible circuit board is manufactured using the tackiness adhesive sheet for thin-film substrate fixing according to the present invention, as shown in Fig. 1, in a state in which a base material film of a flexible circuit board, which is the thin-film substrate 3, is provisionally fixed by the tackiness adhesive sheet for thin-film substrate fixing 2 provided on the hard substrate 1, the flexible circuit board is manufactured by forming a circuit or an element on the base material film of the flexible circuit board or mounting the element on the base material film.

Specifically, the flexible circuit board is obtained by first provisionally fixing the base material film of the flexible circuit board, which is the thin-film substrate 3, on the hard substrate 1 via the tackiness adhesive sheet for thin-film substrate fixing 2, forming, through various kinds of processing of the patterning A, a circuit on the provisionally-fixed base material film of the flexible circuit board, and subsequently fixing the element. The hard substrate 1 for fixing the base material film of the flexible circuit board only has to be capable of holding the base material film of the flexible circuit board and is not specifically limited. However, a material harder than the base material film of the flexible circuit board is preferably used. Examples of the hard substrate 1 include silicon, glass, a SUS plate, a copper plate, and an acrylic plate. The thickness of the hard substrate is preferably 0.01 mm to 10 mm and more preferably equal to or larger than 0.4 mm (e.g., 0.4 mm to 5.0 mm).

A method of affixing a film for flexible circuit board on the hard substrate 1 via the tackiness adhesive sheet for thin-film substrate fixing 2 only has to achieve firm adhesion between the hard substrate 1 and the tackiness adhesive sheet for thin-film substrate fixing 2. The film for flexible circuit board can be affixed on the hard substrate 1 using, for example, a roller, a spatula, a press machine, or the like.

The substrate material forming the flexible circuit board is not specifically limited as long as the base material has heat resistance, dimension stability, a gas barrier property, and surface smoothness. For example, it is possible to use films formed of polycarbonate, polyethylene terephthalate (PET), polyethylene naphthalate (PEN), cyclic olefin polymer, polyarylate, aromatic polyether ketone, aromatic polyether sulfone, wholly aromatic polyketone, liquid crystal polymer, and polyimide. Film formation for improvement of a gas barrier property may be applied to these films when necessary.
A copper-clad laminate, a membrane wiring plate, or a multilayer flexible circuit board may be adopted as the substrate material. A substrate formed by performing via-hole processing or the like can also be used.

The thickness of the films is equal to or smaller than, for example, about 800 µm excluding the thickness of a wiring section, preferably about 3 µm to 700 µm, and particularly preferably about 5 µm to 700 µm.
The flexible circuit board can be flexible circuit boards of a one-sided circuit, a both-sided circuit, a multilayer circuit, and the like. Not only the formation of the circuit, an element or the like can be mounted. To form circuits on both surfaces of the thin-film substrate, it is possible to adopt means for, after forming a circuit on one surface, fixing the circuit forming surface to the hard substrate via the tackiness adhesive sheet for thin-film substrate fixing and forming a circuit on the other surface.
An organic transistor material formed on the base material film of the flexible circuit board is not specifically limited. A low-molecular organic semiconductor material, a high-molecular organic semiconductor material, and an organic/inorganic hybrid semiconductor material can be used. As a gate insulating material, an organic polymer material and an inorganic material can be used.

Means for forming an organic transistor can be a transfer method. An electrode and wiring can be formed by directly drawing the electrode and the wiring on a film. As materials for the electrode and the wiring, metal nano-paste and ink containing metal nano-particles of silver or the like and paste and ink containing nano-particles of a metal oxide can be adopted. A solution of conductive polymer and the like may be adopted.
As a drawing method for the transistor, the electrode, and the wiring, an inkjet method, a screen printing method, gravure printing, flexographic printing, and a nano-print technique can be adopted. Further, a TFT circuit or the like may be formed on the film by transfer.

A layer necessary for forming display layers of a liquid crystal display, an organic EL display, and the like can be further formed on the flexible circuit board in this way. The layer is processed into layer structures corresponding to the respective displays.

In a method of manufacturing the flexible circuit board, after the flexible circuit board manufacturing process, it is preferable to further provide a step of peeling the flexible circuit board from the hard substrate. The peeled flexible circuit board is collected by a well-known common method.

In the flexible circuit board peeling process, it is preferable to reduce a tackiness adhesive force of the tackiness adhesive agent layer of the tackiness adhesive sheet for thin-film substrate fixing and peel the flexible circuit board, which is obtained through the flexible circuit board formation process, from a supporting plate.

When a tackiness adhesive composition having an activated energy-line hardening tackiness adhesive agent layer as the tackiness adhesive agent layer is used and provisionally fixed, tackiness adhesive force can be reduced by irradiating an active energy line (e.g., an ultraviolet ray). Irradiation conditions such as irradiation intensity and irradiation time of the active energy line irradiation are not specifically limited and can be set as appropriate according to necessity.
However, when the flexible circuit board is peeled from the supporting plate by reducing the tackiness adhesive force through heating taking into account heat resistant temperature of the flexible circuit board, the temperature of the heating should be set to temperature lower than the heat resistant temperature. In this regard, means for performing peeling by the active energy line such as the ultraviolet ray is preferable.

When a tackiness adhesive sheet for thin-film substrate fixing having a heat peelable tackiness adhesive agent layer as the tackiness adhesive agent layer is used and provisionally fixed, the tackiness adhesive force can be reduced by heating. Heating means only has to be capable of heating the tackiness adhesive agent layer and quickly expanding a foaming agent such as thermal expansion microspheres contained in the tackiness adhesive agent layer and/or causing the foaming agent to foam. For example, an electric heater, dielectric heating, magnetic heating, heating by an electromagnetic wave such as a near infrared ray, a middle infrared ray, or a far infrared ray, an oven, a hot plate, and the like can be used without limit.
Heating temperature only has to be temperature at which the thermal expansion microspheres contained in the tackiness adhesive agent layer expand and/or foam and temperature at which the formed flexible circuit board is not damaged.

### Organic EL panel manufacturing process

When an organic EL panel is manufactured using the tackiness adhesive sheet for thin-film substrate fixing 2 according to the present invention, in a state in which a supporting film for organic EL panel, which is the thin-film substrate 3, is provisionally fixed by the tackiness adhesive sheet for thin-film substrate fixing 2 formed on the hard substrate 1, the organic EL panel is manufactured by forming a light emitting layer, a layer for adjusting wavelength, a cover layer, and the like on the supporting film for organic EL panel.

Specifically, a resin film not covered with a metal oxide is adopted as the thin-film substrate 3 in the present invention according to necessity. The organic EL panel is obtained by provisionally fixing the resin film on the hard substrate 1 via the tackiness adhesive sheet for thin-film substrate fixing 2 and forming, on the provisionally-fixed resin film, an insulating layer, an electrode of IO, indium oxide, IZO, silver, or the like, a hole transportation layer, a light emitting layer, an electron transportation layer, RGB color filters, and the like in arbitrary order. A material forming the hard substrate 1 only has to be capable of holding an electronic paper supporting film to be affixed and is not specifically limited. However, a material harder than the supporting film for organic EL panel is preferably used. Examples of the material include silicon, glass, a SUS plate, a copper plate, and an acrylic plate. The thickness of such a hard substrate is preferably 0.01 mm to 10 mm and more preferably equal to or larger than 0.4 mm (e.g., 0.4 mm to 5.0 mm).

A method of affixing the supporting film for organic EL panel, which is the thin-film substrate 3, on the hard substrate 1 via the tackiness adhesive sheet for fixing 2 only has to achieve firm adhesion between the hard substrate 1 and the supporting film for organic EL panel. The hard substrate 1 and the supporting film for organic EL panel can be affixed on the hard substrate 1 using, for example, a roller, a spatula, a press machine, or the like.

A material forming the supporting film for organic EL panel, which is the thin-film substrate 3, is not specifically limited as long as the material is excellent in smoothness, a gas barrier property, and a water vapor barrier property and can display flexibility even after the layers necessary for light emission are formed. For example, films formed of polyethylene terephthalate (PET), polyethylene naphthalate (PEN), polyimide, and aromatic polyether sulfone, which can be covered by a resin layer, a barrier layer such as a silicon oxide layer or a silicon nitride layer can be used. In some case, extremely thin glass can be used.

The thickness of such a supporting film for organic EL panel is, for example, equal to or smaller than about 3 mm, preferably about 5 µm to 2.5 mm, and more preferably about 7 µm to 2.5 mm.
Layers for organic EL formed on the supporting film for organic EL panel are the same as the laminated structure for organic EL provided on the glass substrate in the past except a layer for improvement of the water vapor barrier property. As means for laminating the layers, means same as the laminating means on the glass substrate can be adopted.

An organic EL panel to be obtained is not specifically limited. The organic EL panel may be any one of publicly-known forms such as an active type full-color panel, a color flexible panel, a panel having a high molecular hole transportation layer, and a passive type high molecular organic EL panel.

In the method of manufacturing the organic EL panel, it is preferable to further provide a process for peeling the organic EL panel from the hard substrate after the organic EL panel manufacturing process. The peeled organic EL panel is collected by a well-known method.

In the organic EL panel peeling process, it is preferable to reduce the tackiness adhesive force of the tackiness adhesive agent layer of the tackiness adhesive sheet for thin-film substrate fixing and peel the organic EL panel obtained through the organic EL panel formation processing from the hard substrate.

When the tackiness adhesive sheet for thin-film substrate fixing including the activated energy-line hardening tackiness adhesive agent layer as the tackiness adhesive agent layer is used and provisionally fixed, the tackiness adhesive force can be reduced by irradiating an active energy line (e.g., an ultraviolet ray). Irradiation conditions such as irradiation intensity and irradiation time of the active energy line irradiation are not specifically limited and can be set as appropriate according to necessity.
However, when the organic EL panel is peeled from the hard substrate by reducing the tackiness adhesive force through heating taking into account heat resistant temperature of the organic EL panel, the temperature of the heating should be set to temperature lower than the heat resistant temperature. In this regard, means for performing peeling by the active energy line such as the ultraviolet ray is preferable.

When a tackiness adhesive composition having a heat peelable tackiness adhesive agent layer as the tackiness adhesive agent layer is used and provisionally fixed, the tackiness adhesive force can be reduced by heating. Heating means only has to be capable of heating the tackiness adhesive agent layer and quickly expanding a foaming agent such as thermal expansion microspheres contained in the tackiness adhesive agent layer and/or causing the foaming agent to foam. For example, an electric heater, dielectric heating, magnetic heating, heating by an electromagnetic wave such as a near infrared ray, a middle infrared ray, or a far infrared ray, an oven, a hot plate, and the like can be used without limit.
Heating temperature only has to be temperature at which the foaming agent such as the thermal expansion microspheres contained in the tackiness adhesive agent layer expands and/or foams and temperature at which the formed organic EL panel is not damaged.

### Electronic paper manufacturing process

When an electronic paper is manufactured using the tackiness adhesive sheet for thin-film substrate fixing 2 according to the present invention, in a state in which the electronic paper supporting film, which is the thin-film substrate 3, is provisionally fixed by the tackiness adhesive sheet for thin-film substrate fixing 2 affixed on the hard substrate 1, a TFT is formed on the electronic paper supporting film to obtain a driver layer. Further, a display layer having an image display function is affixed on the driver layer to manufacture an electronic paper.

Specifically, the driver layer is obtained by first provisionally fixing the electronic paper supporting film, which is the thin-film substrate 3, on the hard substrate 1 via the tackiness adhesive sheet for thin-film substrate fixing 2 and forming a TFT on the provisionally-fixed electronic paper supporting film. A material forming the hard substrate 1 only has to be capable of holding the electronic paper supporting film to be affixed and is not specifically limited. However, a material harder than the electronic paper supporting film is preferably used. Examples of the material include silicon, glass, a SUS plate, a copper plate, and an acrylic plate. The thickness of the hard substrate is preferably 0.01 mm to 10 mm and more preferably equal to or larger than 0.4 mm (e.g., 0.4 mm to 5.0 mm).

A method of affixing the electronic paper supporting film, which is the thin-film substrate 3, on the hard substrate 1 via the tackiness adhesive sheet for thin-film substrate fixing 2 only has to achieve firm adhesion between the hard substrate 1 and the electronic paper supporting film. The electronic paper supporting film can be affixed on the hard substrate 1 using, for example, a roller, a spatula, a press machine, or the like.

A material forming the electronic paper supporting film is not specifically limited as long as the material can display flexibility even after the electronic paper supporting film is affixed with the display layer. Films formed of polyester such as polyethylene terephthalate (PET) and polyethylene naphthalate (PEN) can be used.
The electronic paper supporting film may be a transparent film or may be an opaque film. Further, the electronic paper supporting film may be a color print film or a color stenciled film or may be a deposited film deposited with gold, silver, or aluminum according to necessity.

The thickness of the electronic paper supporting film is equal to or smaller than, for example, about 2 mm, preferably about 3 µm to 2 mm, and particularly preferably about 5 µm to 2 mm.

A type of the TFT formed on the electronic paper supporting film is not specifically limited. For example, a staggered type, an inverted staggered type, a coplanar type, and an inverted coplanar type can be formed. A semiconductor layer and a gate insulating film forming a transistor, an electrode, a protective insulating film, and the like can be formed in a thin-film shape on the electronic paper supporting film by a method such as vacuum evaporation, sputtering, plasma CVD, or photoresist in the same manner as the normal TFT formation.

The display layer is a layer having an image display function. An image display form of the display layer is not specifically limited as long as the display layer has a display function by electricity or magnetism. For example, a twist ball system, an electrophoresis system, and a charged toner display system can be adopted.

A method of affixing the display layer and the electronic paper supporting film on which the TFT is formed only has to be capable of closely attaching the display layer and the electronic paper supporting film on which the TFT is formed. The display layer and the electronic paper supporting film can be affixed using, for example, a roller, a spatula, a press machine, or the like.
Although not particularly necessary when the tackiness adhesive sheet for thin-film substrate fixing is provided on the rear surface of the display layer in order to make the display layer adhere to the electronic paper supporting film on which the TFT is formed, when the tackiness adhesive agent layer is not provided on the rear surface of the display layer, the electronic paper supporting film on which the TFT is formed can adhere to the rear surface using a general adhesive agent.

In the method of manufacturing an electronic paper according to the present invention, after the electronic paper formation process, it is preferable to further provide a process for peeling the electronic paper from the hard substrate. The peeled electronic paper is collected by a well-known method.

In the electronic paper peeling process, it is preferable to reduce the tackiness adhesive force of the tackiness adhesive sheet for thin-film substrate fixing and peel, from the hard substrate, the electronic paper obtained through the electronic paper formation process.

When a tackiness adhesive composition having an activated energy-line hardening tackiness adhesive agent layer as the tackiness adhesive agent layer of the tackiness adhesive sheet for thin-film substrate fixing is used and provisionally fixed, tackiness adhesive force can be reduced by irradiating an active energy line (e.g., an ultraviolet ray). Irradiation conditions such as irradiation intensity and irradiation time of the active energy line irradiation are not specifically limited and can be set as appropriate according to necessity.

When a tackiness adhesive sheet for thin-film substrate fixing having a heat peelable tackiness adhesive agent layer as the tackiness adhesive agent layer is used and provisionally fixed, the tackiness adhesive force can be reduced by heating. Heating means only has to be capable of heating the tackiness adhesive agent layer and quickly expanding a foaming agent such as thermal expansion microspheres contained in the tackiness adhesive agent layer and/or causing the foaming agent to foam. For example, an electric heater, dielectric heating, magnetic heating, heating by an electromagnetic wave such as a near infrared ray, a middle infrared ray, or a far infrared ray, an oven, a hot plate, and the like can be used without limit.
Heating temperature only has to be temperature at which the foaming agent such as the thermal expansion microspheres contained in the tackiness adhesive agent layer expands and/or foams.

### Measuring method

Measurement of physical properties of a base material functioning as a porous base material Porosity measurement: With porosity(%)={ (weight/density)/volume}×100, the volume and the weight of a porous film were measured and porosity was calculated by the above Equation using the density of a porous film material.

Hole diameter and hole area measurement: Concerning the porous film, photographing was performed using a scanning electron microscope (SEM) and an average hole diameter was calculated from an image analysis of a photograph taken by the photographing. At the same time, an average hole area was calculated.

CTE measurement: A base material sample having bore holes were cut into a shape of strips each having the width of 3 mm, held between chucks for stretching, and TMA measurement was performed in an MD direction and a TD direction. As an apparatus, TMA/SS6000 manufactured by SII NanoTechnology Inc. was used. A measurement mode of a pulling method was used. A Max value of an average coefficient of linear expansion of TD and MD at a load of 19.6 mN, a chuck interval of 10 mm, a temperature program: room temperature⇒200°C, temperature rise speed: 5°C/minute, and at 140°C to 160°C in measurement atmosphere: nitrogen (flow rate of 200 ml/minute) was calculated as a CTE value at 150°C.

### Evaluation

### Thin-film substrate floating during heating

A tackiness adhesive sheet of a double-sided type having a size of 300mm×300mm formed on the basis of an example explained below was affixed on glass (0.5mm thick) functioning as a hard substrate. Further, Kapton 150EN (thickness: 37.5 µm) manufactured by Toray Industries, Inc. was fixed on the tackiness adhesive sheet as a thin-film substrate by affixing. Thereafter, under a condition of 150°C×1 hour, these substrates were placed on a hot plate and a ratio (%) of an area of air bubbles generated in a plane until one hour elapsed was described. An evaluation was performed with N=3. An average (%) of the evaluation was described.

### Substrate positional displacement during heating

A tackiness adhesive sheet of a double-sided type having a size of 600mmx600mm formed on the basis of the example explained below was affixed on glass (0.5mm thick) functioning as a hard substrate. Further, Kapton 150EN (thickness: 37.5 µm) manufactured by Toray Industries, Inc. was fixed on the tackiness adhesive sheet as a thin-film substrate by affixing. Marked lines were written on the same positions on the substrate and the glass at an interval of 0.5 mm.
Thereafter, under a condition of 150°C×1 hour, these substrates were put in and taken out from a drier. Then, after they are left at room temperature for 30 minutes at rest, if the positions of the marked lines on the outermost periphery deviated 1 mm or more between the thin-film substrate and the film, it was evaluated that positional displacement was present and, if the displacement was within 0.5 mm, it was evaluated that positional displacement was absent (N=3). When floating occurred between a tackiness adhesive agent and the thin-film substrate when the tackiness adhesive sheet for thin-film substrate fixing was taken out, a ratio (%) of a floating area to the entire tackiness adhesive sheet for thin-film substrate fixing was described.

### In-plane uniformity

A tackiness adhesive sheet of a double-sided type having a size of 50mm×50mm formed on the basis of the example explained below was affixed on glass (0.5mm thick) functioning as a hard substrate. Further, Kapton 150EN (thickness: 37.5 µm) manufactured by Toray Industries, Inc. was fixed on the tackiness adhesive sheet as a thin-film substrate by affixing. Distances of 10 mm in the longitudinal and lateral directions from the center were measured A (N=3) using a contact-type surface roughness measuring machine (P-15 manufactured by KLA Tencor) on the surface of the thin-film substrate, which was a sample of this evaluation. In the measurement, when a difference between a maximum and a minimum of height was smaller than 20 µm, it was evaluated that the in-plane uniformity was good. When the difference was equal to or larger than 20 µm, it was evaluated that the in-plane uniformity was poor.

### Examples

### Tackiness layer A

45 mol of ethylacrylate and 20 mol of 2-hydroxyethylacrylate were copolymerized with 40 mol of butylacrylate in ethyl acetate by the usual method. An NCO radical of 2-ethylene methacryloyloxy isocyanate was caused to additionally react to 70% of a side-chain terminus OH radical of 2-hydroxyethylacrylate to obtain a solution containing acrylic copolymer having a weight average molecular weight of 500,000 with carbon-to-carbon double bond given to an end.
Subsequently, 3 pts.wt. of a photoinitiator (product name "Irgacure 127") manufactured by BASF and 3 pts.wt. of a polyisocyanate compound (product name "Coronate L") manufactured by Nippon Polyurethane Industry Co., Ltd. were added to 100 pts.wt. of a solution containing the acrylic copolymer to obtain an acrylic ultraviolet curing tackiness adhesive agent solution.
After this tackiness adhesive agent solution was applied over a polyester film subjected to release treatment, the polyester film was thermally crosslinked at 120°C for 5 minutes. Consequently, a tackiness adhesive agent layer having thickness of 15 µm was obtained.

### Tackiness layer B

70 pts.wt. of methylacrylate and 15 pts.wt of acrylic acid were copolymerized with 20 pts.wt. of 2-ethylhexyl acrylate in ethyl acetate by the usual method to obtain a solution containing an acrylic copolymer having a weight average molecular weight of 700,000. Subsequently, 0.2 pts.wt. of epoxy resin (product name "TETRAD-C") manufactured by Mitsubishi Gas Chemical Company, Inc.) was added to 100 pts.wt. of a solution containing the acrylic copolymer to obtain an acrylic tackiness adhesive agent solution.
After this tackiness adhesive agent solution was applied over a polyester film subjected to release treatment, the polyester film was thermally crosslinked at 120°C for 5 minutes. Consequently, a tackiness adhesive agent layer having thickness of 15 µm was obtained.

### Adhesive layer C

100 pts.wt. of a diene block copolymer (Tuftec M1943 manufacture by Asahi Kasei Corporation), 10 pts.wt. of rosin resin (KE604 manufactured by Arakawa Chemical Industries, Ltd.), 0.05 pts.wt. of epoxy resin (TETRAD-C manufactured by Mitsubishi Gas Chemical Company Inc.), 1 pts.wt. of a silane coupling agent (KBM-403 manufactured by Shin-Etsu Chemical Co., Ltd.), and 450 pts.wt. of toluene were mixed to prepare adhesive varnish. After the adhesive varnish was applied over a polyester film subjected to release treatment, the polyester film was heated to 130°C to remove a solvent to obtain an adhesive agent layer having thickness of 15 µm.

### Adhesive layer D

18 pts.wt. of crylonitrile butadiene rubber (PNR-1H manufactured by JSR Corporation), 44 pts.wt. of epoxy resin (YX-4000H manufactured by Yuka Shell Epoxy Kabushiki Kaisha, 30 pts.wt. of phenol resin (Tamanol P-180 manufactured by Arakawa Chemical Industries, Ltd.), 0.5 pts.wt. of imidazole (Curezol 2PZ-CN manufactured by Shikoku Chemicals Corporation), and 200 pts.wt. of methyl ethyl ketone were mixed to prepare an adhesive varnish. After the adhesive varnish was applied over a polyester film subjected to release treatment, the polyester film was heated to 130°C to remove a solvent to obtain an adhesive agent layer having thickness of 15 µm.

### Polyimide porous base material A

16 pts.wt. of BTC polyimide (polymer obtained by thermally imidizing butanetetracarboxylic acid and diaminodiphenyl ether manufactured by Nitto Denko Corporation), 7 pts.wt. of polyvinylpyrrolidone (K-90 manufactured by ISP Japan Ltd., 71 pts.wt. of N-methyl-2-pyrrolidone, and 8 pts.wt. of water were mixed to obtain a solution.
After the solution was applied and flow-casted over a polyester film having thickness of 50 µm, the polyester film was immersed in water and solidified and then cleaned and dried to form, with a phase transition method, a porous base material functioning as a core material at thickness of 50 µm.

### Example 1

The tackiness agent layer A and the adhesive agent layer C were affixed on both surfaces of a porous base material of polytetrafluoroethylene (PTFE) having thickness of 150 µm such that the porous base material and the tackiness adhesive agent layers are in contact with each other under a condition of temperature of 90°C to form a double-sided adhesive sheet including a base material having bore holes. The tackiness agent layer A and the adhesive agent layer C were respectively formed as thin-film substrate and hard substrate affixing surfaces.

### Example 2

After a tackiness agent layer surface of the tackiness agent layer B was affixed to the polyimide porous base material A at 90°C, a process film in contact with the porous base material was removed. The adhesive agent layer D was affixed to the surface in the same manner at 90°C such that the adhesive agent layer D and the surface are in contact with each other to form a double-sided adhesive sheet. The tackiness agent layer B and the adhesive layer D were respectively formed as thin-film substrate and hard substrate affixing surfaces.

### Example 3

The tackiness agent layers A and B were affixed to a base material of Kapton 150EN manufactured by Du Toray Industries, Inc. (thickness: 37.5 µm) at 60°C to obtain a double-sided pressure-sensitive adhesive sheet. The sheet was worked using a precision film punching machine RFP-S20 (manufactured by UHT Corporation) to form a circular hole of 0.2 mm² to pierce from the upper surface to the lower surface to form a double-sided adhesive sheet having a through-hole in the same portion of the tackiness agent layer and the base material. The tackiness agent layer A and the tackiness agent layer B were respectively formed as thin-film substrate and hard substrate affixing surfaces.

### Comparative Example 1

The tackiness agent layers A and B were affixed to a base material of Kapton 150EN manufactured by Du Toray Industries, Inc. (thickness: 37.5 µm) at 60°C to obtain a double-sided pressure-sensitive adhesive sheet.

### Comparative Example 2

A double-sided adhesive sheet was formed in the same method as Example 1 except that a porous base material having porosity of 96% was used as the porous base material of polytetrafluoroethylene (PTFE) having thickness of 150 µm.

### Comparative Example 3

The same procedure as Example 3 was carried out except that the double-sided sheet of Example 3 was used and the sheet was worked using the precision film punching machine RFP-S20 (manufactured by UHT Corporation) to form a circular hole of 5 mm² to pierce from the upper surface to the lower surface to form a double-sided adhesive sheet having a through-hole in the same portion of the tackiness agent layer and the base material.

**[Table 1]**

| | | Example 1 | Example 2 | Example 3 | Comparative Example 1 | Comparative Example 2 | Comparative Example 3 |
|---|---|---|---|---|---|---|---|
| Base material | Thickness (µm) | 150 | 50 | 37.5 | 37.5 | 150 | 37.5 |
| | Porosity (%) | 80 | 60 | 30 | - | 96 | 45 |
| | Hole diameter (µm) | 2 | 1 | 280 | - | 2 | 1200 |
| | Hole area (µm²) | 4 | 0.8 | 0.2 | - | 4 µ | 5 |
| | CTE value | 200 | 70 | 8 | 18 | 160 | 6 |
| Evaluat ion | Floating during heating | 0 % | 0 % | 0 % | 90 % | 0 % | 0 % |
| | Substrate positional displacement during heating | No | No | No | Yes | No | No |
| | In-plane uniformity | Good | Good | Good | Good | Poor | Poor |

In Examples 1 to 3, the tackiness adhesive sheet for fixing and the thin-film substrate satisfying the requirements specified in the present invention were used. Therefore, it is possible to confirm a remarkable effect that positional displacement and floating do not occur in the thin-film substrate even during heating and the surface of the thin-film substrate is smooth.
On the other hand, as in Comparative Example 1, when the porous base material was not used and the tackiness adhesive agent layer was simply provided, floating during heating was 90% and substrate positional displacement was observed during heating. This indicates that since gas such as water generated during heating stays on the tackiness adhesive sheet for thin-film substrate fixing, the thin-film substrate is lifted by the gas.
In Comparative Example 2, since the porosity of the porous base material was as high as 96%, although floating during heating and substrate positional displacement during heating were not observed, in-plane uniformity was poor and unevenness was observed on the surface of the thin-film substrate.
In Comparative Example 3, the hole area of the porous base material was set large. Therefore, although floating during heating and substrate positional displacement during heating were not observed, in-plane uniformity was poor and unevenness was observed on the surface of the thin-film substrate.

### Reference Signs List

- 1: hard substrate
- 2: tackiness adhesive sheet for thin-film substrate fixing
- 3: thin-film substrate
- A: patterning
- 4: tackiness adhesive agent layer
- 5: porous base material

## Claims

1. A tackiness adhesive sheet for thin-film substrate fixing used in performing pattern formation on a thin-film substrate, wherein the pattern formation is performed in a state in which the thin-film substrate, the tackiness adhesive sheet for fixing, and a hard substrate are laminated in order, the tackiness adhesive sheet for fixing in use includes a porous base material, a porosity of the porous base material is 5% to 95%, and a hole diameter of the porous base material is 0.01 µm to 900 µm.

2. The tackiness adhesive sheet for thin-film substrate fixing according to claim 1, wherein a hole area of the porous base material of the tackiness adhesive sheet for fixing is 0.0001 µm² to 4 mm².

3. The tackiness adhesive sheet for thin-film substrate fixing according to claim 1 or 2, wherein multiple holes of the porous base material are formed of bore holes, and the bore holes are continuously opened through from the porous base material to a tackiness adhesive agent layer.

4. The tackiness adhesive sheet for thin-film substrate fixing according to any one of claims 1 to 3, comprising a tackiness adhesive agent layer for re-peeling in at least one piece of the porous base material.

5. The tackiness adhesive sheet for thin-film substrate fixing according to any one of claims 1 to 4, wherein CTE at 150°C of the porous base material is equal to or lower than 500 ppm.

6. The tackiness adhesive sheet for thin-film substrate fixing according to any one of claims 1 to 5, wherein the tackiness adhesive sheet for thin-film substrate fixing is used when formation of a pattern on the thin-film substrate including a process performed at 80°C to 270°C is performed.

7. A member for thin-film substrate fixing formed by laminating the tackiness adhesive sheet for thin-film substrate fixing according to any one of claims 1 to 6 on a hard substrate.

8. A method of forming a pattern on a thin-film substrate in a state in which the thin-film substrate, a tackiness adhesive sheet for fixing, and a hard substrate are laminated in order, wherein the tackiness adhesive sheet for thin-film substrate fixing according to any one of claims 1 to 6 is used as the tackiness adhesive sheet for fixing.
